# EUROPÄISCHE PATENTANMELDUNG

(11) **EP 1 965 623 A2**
(43) Veröffentlichungstag der Anmeldung: **03.09.2008**
(21) Anmeldenummer: 08003248.5
(22) Anmeldetag: 22.02.2008
(51) Int. Cl.: H05K 5/02

(54) **Gehäuse**

(30) Priorität: 02.03.2007 DE 102007010665
(71) Anmelder: Viessmann Werke GmbH & Co. KG, 35107 Allendorf (DE)
(72) Erfinder: Gücker, Ludolf, 35116 Reddighausen (DE)
(74) Vertreter: Wolf, Michael

(57) **Zusammenfassung**

Die Erfindung betrifft ein Gehäuse, bestehend aus einer metallischen Bodenplatte (1), Seitenwänden (2) und einem Deckel (3). Nach der Erfindung ist vorgesehen, dass die Seitenwände (2) aus Kunststoff gebildet sind.

## Beschreibung

Die Erfindung betrifft ein Gehäuse gemäß dem Oberbegriff des Patentanspruchs 1.

Ein spezielles Gehäuse der eingangs genannten Art ist nach der DE 295 03 735 U1 bekannt. Dieses besteht aus einer metallischen Bodenplatte, metallischen Seitenwänden und einem metallischen Deckel. Es dient zur Aufnahme von Hochfrequenzschaltungen und ist zur Abschirmung vollständig aus Metall gebildet. Diesbezüglich wird auch auf das Gehäuse gemäß der DE 39 40 842 A1 verwiesen.

Aus der DE 101 61 016 A1 ist ferner ein Gehäuse zur Aufnahme von elektrischen oder elektronische Bauteilen bekannt, bei dem alle Gehäusebauteile aus Kunsttoff gebildet sind, mithin auch der sogenannte Grundkörper, der gewissermaßen den Boden des Gehäuses bildet. Diesen Grundkörper gibt es allerdings nur in einer bestimmten Größe, eine Variablität bezüglich der Gehäusegestaltung ergibt sich somit lediglich durch verschiedene auf den Grundkörper aufsetzbare Ansatzkörper, die in der Regel gleichzeitig Wand und Decke bzw. Deckel bilden.

Der Erfindung liegt die Aufgabe zugrunde, ein neues Konzept für ein Gehäuse bereit zu stellen, mit dem auf einfache Weise unterschiedliche Gehäusegrößen bildbar sind, dies allerdings verbunden mit der Maßgabe, dass das Gehäuse fertigungstechnisch sehr einfach und kostengünstig herstellbar ist, und zwar auch bei relativ kleinen Stückzahlen und dementsprechend niedrigen Investitionkosten für die Fertigungswerkzeuge.

Diese Aufgabe ist mit einem Gehäuse der eingangs genannten Art durch die im Kennzeichen des Patentanspruchs 1 aufgeführten Merkmale gelöst.

Nach der Erfindung ist also vorgesehen, dass die Seitenwände aus Kunststoff gebildet sind.

Mit anderen Worten ausgedrückt, ergibt sich durch die Kombination einer metallischen Bodenplatte mit Seitenwänden aus Kunststoff ein sehr variables Gehäusekonzept, denn einerseits läßt sich die vorzugsweise rechteckig ausgebildete Bodenplatte sehr einfach und in verschiedenen Größen herstellen und andererseits können für die Seitenwände ohne Weiteres kompliziertere Geometrien (zum Beispiel mit einer Leitungseinführung, einer Zugentlastung usw.) vorgesehen werden, da solche durch Kunststoffspritzguss leicht erzeugbar sind.

Besonders bevorzugt ist vorgesehen, dass mindestens eine Seitenwand aus mindestens zwei Einzelwandmodulteilen gebildet ist. Diese erfindungsgemäße Maßgabe führt letztlich dazu, dass ganz unterschiedliche Gehäusegrößen auf Basis eines Baukastenprinzips erstellbar sind. Dabei sind die Seitenteile bzw. Einzelwandmodulteile vergleichsweise klein, können also zum Beispiel mit relativ kostengünstigen Kunststoffspritzwerkzeugen erzeugt werden. Die Bodenplatte und der Deckel, die ja bezogen auf die Seitenwände recht groß sind, sind dagegen leicht und kostengünstig per Blechbearbeitung herstellbar, da ja lediglich ein Größenzuschnitt und gegebenenfalls eine Abkantung am Rand erforderlich ist.

Andere vorteilhafte Weiterbildungen ergeben sich aus den abhängigen Patentansprüchen.

Das erfindungsgemäße Gehäuse einschließlich seiner vorteilhaften Weiterbildungen gemäß der abhängigen Patentansprüche wird nachfolgend anhand der zeichnerischen Darstellung mehrerer Ausführungsbeispiele näher erläutert.

Es zeigt
- Figur 1: als Explosionsdarstellung eine erste Ausführungsform des erfindungsgemäßen Gehäuses;
- Figur 2: in Draufsicht (ohne Deckel) das Gehäuse gemäß Figur 1 (zusammengebaut); und
- Figur 3: perspektivisch und teilweise geschnitten eine weitere Ausführungsform des erfindungsgemäßen Gehäuses.

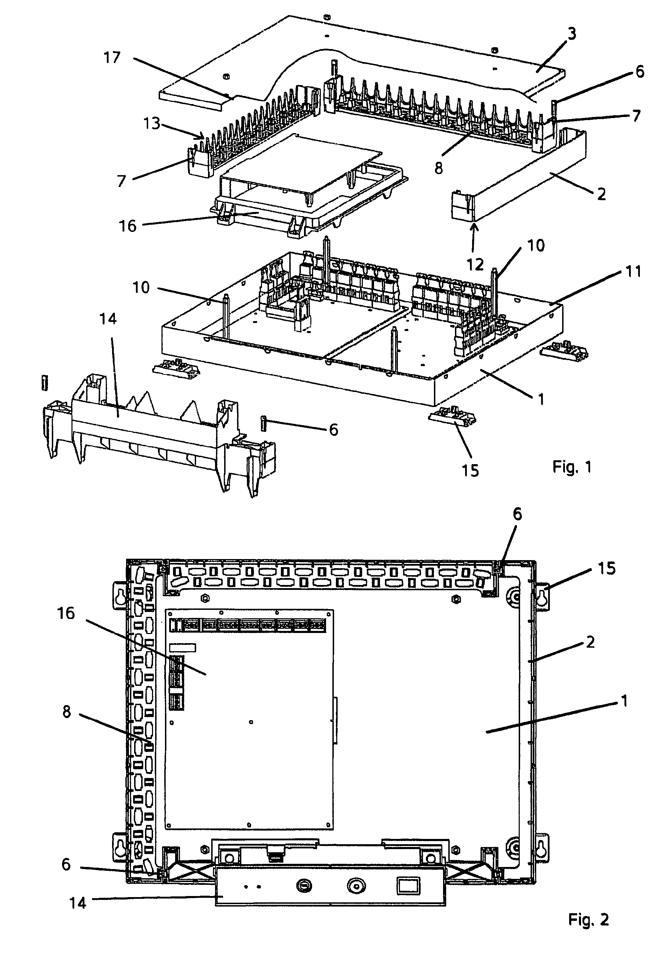

Das in den Figuren 1 bis 3 dargestellte Gehäuse besteht aus einer metallischen Bodenplatte 1, Seitenwänden 2 und einem Deckel 3. Im Innern dieses Gehäuses sind elektrische bzw. elektronische Bauteile 16 eines wärmetechnischen Geräts, insbesondere einer Heizungsanlage, angeordnet. Der Deckel 3 ist wie die Bodenplatte 1 bei den dargestellten Ausführungsformen aus Metall gebildet. Beide weisen der einfachen Herstellbarkeit halber eine rechteckige Grundform auf.

Das Gehäuse selbst ist (nicht extra dargestellt) im Innern eines Heizkesselumschließungsgehäuses angeordnet (befestigt mit den Befestigungselementen 15), d. h. beim vorgesehenen Anwendungsfall ist es von außerhalb des Heizkessels nicht sichtbar. Aus Figur 1 und 2 geht aber hervor, dass am Gehäuse ein Verbindungsbauteil 14 vorgesehen sein kann, das im Prinzip wie eine Seitenwand ausgebildet ist, das aber einen über das Gehäuse hinausragenden Randbereich aufweist, an den zum Beispiel ein außen am Heizkesselgehäuse angeordnetes Reglergehäuse anschließt. Wie in Figur 1 angedeutet dargestellt, kann dabei auch am Deckel 3 eine entsprechende Ausnehmung 17 vorgesehen sein.

Wesentlich für alle Ausführugsformen des erfindungsgemäßen Gehäuses ist nun, dass die Seitenwände 2 aus Kunststoff gebildet sind.

Diese Maßgabe führt, wie eingangs erläutert, zu einem sehr kostengünstig herstellbaren Gehäuse, bei dem die Seitenwände 2 sandwichartig zwischen der Bodenplatte 1 und dem Deckel 3 angeordnet sind, bzw. letztlich sogar zu einem Baukastenprinzip, mit dem auf Basis fertigungstechnisch leicht und preiswert herstellbarer Einzelbauteile eine Vielzahl unterschiedlicher Gehäusegrößen schnell erstellt werden können. Diese Variabilität ist insbesondere beim Bau von Heizkesseln bzw. bei der Anordnung der Regelungskomponenten solcher Heizkessel sehr vorteilhaft, kann aber natürlich auch bei alle möglichen anderen Anwendungsfällen zum Vorteil gereichen.

Bezüglich der Herstellung der Seitenwände 2 aus Kunststoff hat es sich dabei als besonders vorteilhaft erwiesen, diese als Kunststoffspritzgussbauteile auszubilden. Die Formen für die relativ kleinen Bauteile lassen sich zu geringen Kosten herstellen, gleichzeitig können die Bauteile aber durchaus eine gewisse geometrische Komplexität aufweisen, die auf andere Weise nur zu erheblich höheren Kosten herstellbar wäre.

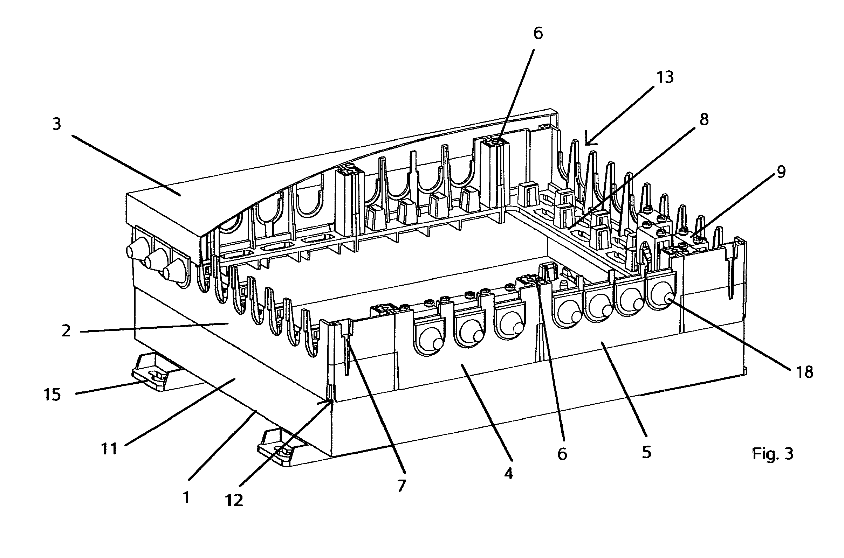

Mit Verweis auf Figur 3 besteht eine besonders bevorzugte Weiterbildung der Erfindung darin, dass mindestens eine Seitenwand 2 aus mindestens zwei Einzelwandmodulteilen 4, 5 gebildet ist. Gerade diese Maßgabe gewährleistet auch bei größeren Gehäusen, dass die Seitenwände 2 aus mehreren Einzelteilen zusammensetzbar sind und damit leicht (weil relativ klein) hergestellt werden können.

Zur Gewährleistung einer gewissen Gehäusestabilität ist zwischen benachbarten Rändern der Einzelwandmodulteile 4, 5 mindestens ein Verbindungselement 6 vorgesehen. Dieses Verbindungselement 6 ist besonders bevorzugt als formschlüssig in jeweils eine Nut 7 an den Einzelwandmodulteilen 4, 5 einsteckbares Steckelement ausgebildet, d. h. die Seitenwände 2 ergeben sich letztlich aus einem aus Einzelwandmodulteilen 4, 5 und Verbindungselementen 6 bestehenden Stecksystem, das sehr leicht montierbar ist. Dabei hat es sich als besonders praktisch erwiesen, die baukastenmäßig bereitstehenden Einzelwandmodulteile 4, 5 in unterschiedlichen Grössen vorzuhalten.

Bezüglich der Gestaltung im einzelnen ist vorgesehen, dass das Einzelwandmodulteil 4, 5 in einer Schnittebene parallel zur Bodenplatte 1 einen U-förmigen Querschnitt aufweist (siehe insbesondere Figur 1). Diese Maßgabe führt dazu, dass ein Eckbereich des Gehäuses praktisch von einer Seitenwand gebildet wird, mithin der Übergang von einem Seitenteil zum nächsten nicht auf eine Ecke des Gehäuses fällt. Darüber hinaus ergibt sich durch diese Gestaltung aber auch mehr Gestaltungsspielraum bezüglich der Anbindung der Verbindungselemente 6 bzw. der Anordnung entsprechender Nuten 7.

Ferner ist vorgesehen, dass das Einzelwandmodulteil 4, 5 in einer Schnittebene senkrecht zur Bodenplatte 1 einen L-förmigen Querschnitt aufweist. Wie besonders gut aus Figur 3 ersichtlich, ergibt sich durch diese Maßgabe Raum zur Anordnung von zum Beispiel Leitungsbefestigungselementen 9, von denen eine Vielzahl auf dem horizontal verlaufenden Schenkel 8 des Einzelwandmodulteils untergebracht sind. Dabei ist mindestens eine Seitenwand 2 mit mindestens einer Leitungszuführungsöffnung 13 versehen, die ihrerseits mit einem entsprechend formangepaßten, an sich bekannten Verschlusselement 18 verschlossen sein kann.

Wie Figur 1 zeigt, sind die Bodenplatte 1 und der Deckel 3 miteinander über Stehbolzen 10 fest, aber lösbar verbunden (verschraubt). Bezüglich der Anbindung der Seitenwände 2 an die Bodenplatte 1 ist schließlich besonders bevorzugt vorgesehen, dass die Bodenplatte 1 an ihren Rändern mit Abkantungen 11 versehen ist, wobei die Seitenwände 2 bodenplattenseitig zu den Abkantungen 11 formschlüssig ausgebildete Nuten 12 aufweisen.

### Bezugszeichenliste

- 1: Bodenplatte
- 2: Seitenwand
- 3: Deckel
- 4: Einzelwandmodulteil
- 5: Einzelwandmodulteil
- 6: Verbindungselement
- 7: Nut
- 8: Schenkel
- 9: Leitungsbefestigungselement
- 10: Stehbolzen
- 11: Abkantung
- 12: Nut
- 13: Leitungszuführungsöffnung
- 14: Verbindungsbauteil
- 15: Befestigungselement
- 16: Bauteile
- 17: Ausnehmung
- 18: Verschlusselement

## Patentansprüche

1. Gehäuse, bestehend aus einer metallischen Bodenplatte (1), Seitenwänden (2) und einem Deckel (3),
**dadurch gekennzeichnet,**
**dass** die Seitenwände (2) aus Kunststoff gebildet sind.

2. Gehäuse nach Anspruch 1,
**dadurch gekennzeichnet,**
**dass** mindestens eine Seitenwand (2) aus mindestens zwei Einzelwandmodulteilen (4, 5) gebildet ist, wobei vorzugsweise zwischen benachbarten Rändern der Einzelwandmodulteile (4, 5) mindestens ein Verbindungselement (6) vorgesehen ist, wobei vorzugsweise das Verbindungselement (6) als formschlüssig in jeweils eine Nut (7) an den Einzelwandmodulteilen (4, 5) einsteckbares Steckelement ausgebildet ist, wobei vorzugsweise Einzelwandmodulteile (4, 5) in unterschiedlichen Grössen vorgesehen sind, wobei vorzugsweise das Einzelwandmodulteil (4, 5) in einer Schnittebene parallel zur Bodenplatte (1) einen U-förmigen Querschnitt aufweist, wobei vorzugsweise das Einzelwandmodulteil (4, 5) in einer Schnittebene senkrecht zur Bodenplatte (1) einen L-förmigen Querschnitt aufweist, wobei vorzugsweise auf einem horizontalen Schenkel (8) des im Querschnitt L-förmig ausgebildeten Einzelwandmodulteils (4, 5) mindestens ein Leitungsbefestigungselement (9) angeordnet ist.

3. Gehäuse nach Anspruch 1 oder 2,
**dadurch gekennzeichnet,**
**dass** die Seitenwände (2) sandwichartig zwischen der Bodenplatte (1) und dem Deckel (3) angeordnet sind.

4. Gehäuse nach einem der Ansprüche 1 bis 3,
**dadurch gekennzeichnet,**
**dass** die Bodenplatte (1) und der Deckel (3) miteinander über Stehbolzen (10) fest, aber lösbar verbunden sind.

5. Gehäuse nach einem der Ansprüche 1 bis 4,
**dadurch gekennzeichnet,**
**dass** die Bodenplatte (1) an ihren Rändern mit Abkantungen (11) versehen ist, wobei vorzugsweise die Seitenwände (2) bodenplattenseitig zu den Abkantungen (11) formschlüssig ausgebildete Nuten (12) aufweisen.

6. Gehäuse nach einem der Ansprüche 1 bis 5,
**dadurch gekennzeichnet,**
**dass** der Deckel (3) aus Metall gebildet ist.

7. Gehäuse nach einem der Ansprüche 1 bis 6,
**dadurch gekennzeichnet,**
**dass** wahlweise die Bodenplatte (1) und/oder der Deckel (3) rechteckig ausgebildet ist.

8. Gehäuse nach einem der Ansprüche 1 bis 7,
**dadurch gekennzeichnet,**
**dass** mindestens eine Seitenwand (2) mit mindestens einer Leitungszuführungsöffnung (13) versehen ist.

9. Gehäuse nach einem der Ansprüche 1 bis 8,
**dadurch gekennzeichnet,**
**dass** die Seitenwände (2) als Kunststoffspritzgussbauteile ausgebildet sind.

10. Gehäuse nach einem der Ansprüche 1 bis 9,
**dadurch gekennzeichnet,**
**dass** im Innern des Gehäuses elektrische oder elektronische Bauteile eines wärmetechnischen Geräts, insbesondere einer Heizungsanlage, angeordnet sind, wobei vorzugsweise das Gehäuse im Innern eines Heizkesselumschließungsgehäuses angeordnet ist.
